(19) Europäisches Patentamt
European Patent Office
Office européen des brevets

(11) **EP 3 011 648 B1**

(12) **EUROPÄISCHE PATENTSCHRIFT**

(45) Veröffentlichungstag und Bekanntmachung des Hinweises auf die Patenterteilung:
**29.05.2019 Patentblatt 2019/22**

(21) Anmeldenummer: **14742458.4**

(22) Anmeldetag: **12.06.2014**

(51) Int Cl.:
*H01S 5/065* [(2006.01)]    *H03K 3/42* [(2006.01)]

(86) Internationale Anmeldenummer:
**PCT/DE2014/200257**

(87) Internationale Veröffentlichungsnummer:
**WO 2014/202074 (24.12.2014 Gazette 2014/52)**

(54) **OPTOELEKTRONISCHER OSZILLATOR**

OPTOELECTRONIC OSCILLATOR

OSCILLATEUR OPTOÉLECTRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.06.2013 DE 102013211633**

(43) Veröffentlichungstag der Anmeldung:
**27.04.2016 Patentblatt 2016/17**

(73) Patentinhaber: **Technische Universität Berlin 10623 Berlin (DE)**

(72) Erfinder:
• **ARSENIJEVIC, Dejan**
  **10627 Berlin (DE)**
• **KLEINERT, Moritz**
  **13187 Berlin (DE)**
• **BIMBERG, Dieter**
  **14089 Berlin (DE)**

(74) Vertreter: **Fischer, Uwe**
  **Patentanwalt**
  **Moritzstraße 22**
  **13597 Berlin (DE)**

(56) Entgegenhaltungen:
• FIOL G ET AL: "1.3 [mu]m range 40 GHz quantum-dot mode-locked laser under external continuous wave light injection or optical feedback", SEMICONDUCTOR SCIENCE AND TECHNOLOGY, IOP PUBLISHING LTD, GB, Bd. 26, Nr. 1, 15. November 2010 (2010-11-15), Seite 14006, XP020202442, ISSN: 0268-1242, DOI: 10.1088/0268-1242/26/1/014006 in der Anmeldung erwähnt

• OTTO C ET AL: "Delay-induced dynamics and jitter reduction of passively mode-locked semiconductor lasers subject to optical feedback", NEW JOURNAL OF PHYSICS, INSTITUTE OF PHYSICS PUBLISHING, BRISTOL, GB, Bd. 14, Nr. 11, 22. November 2012 (2012-11-22), Seite 113033, XP020231692, ISSN: 1367-2630, DOI: 10.1088/1367-2630/14/11/113033

• BIMBERG D ET AL: "Nanophotonics for datacom and telecom applications", PROCEEDINGS OF SPIE, S P I E - INTERNATIONAL SOCIETY FOR OPTICAL ENGINEERING, US, Bd. 8265, 25. Januar 2012 (2012-01-25), Seiten 1-7, XP009180205, ISSN: 0277-786X ISBN: 978-0-89252-037-4

• ARSENIJEVIC D ET AL: "Phase noise and jitter reduction by optical feedback on passively mode-locked quantum-dot lasers", APPLIED PHYSICS LETTERS, AMERICAN INSTITUTE OF PHYSICS, US, Bd. 103, Nr. 23, 2. Dezember 2013 (2013-12-02), XP012178948, ISSN: 0003-6951, DOI: 10.1063/1.4837716 [gefunden am 1901-01-01]

• CHANG-YI LIN ET AL: "Microwave Characterization and Stabilization of Timing Jitter in a Quantum-Dot Passively Mode-Locked Laser via External Optical Feedback", IEEE JOURNAL OF SELECTED TOPICS IN QUANTUM ELECTRONICS, IEEE SERVICE CENTER, PISCATAWAY, NJ, US, vol. 17, no. 5, 1 September 2011 (2011-09-01), pages 1311-1317, XP011477859, ISSN: 1077-260X, DOI: 10.1109/JSTQE.2011.2118745

- **BREUER S ET AL: "Investigations of Repetition Rate Stability of a Mode-Locked Quantum Dot Semiconductor Laser in an Auxiliary Optical Fiber Cavity", IEEE JOURNAL OF QUANTUM ELECTRONICS, IEEE SERVICE CENTER, PISCATAWAY, NJ, USA, vol. 46, no. 2, 1 February 2010 (2010-02-01), pages 150-157, XP011286528, ISSN: 0018-9197, DOI: 10.1109/JQE.2009.2033255**

**Beschreibung**

Die Erfindung bezieht sich auf einen optoelektronischen Oszillator zur Erzeugung eines optischen und/oder elektrischen Pulskammes mit einem monolithisch integrierten passiv modengekoppelten Halbleiterlaser und mit einer optischen Rückkopplungsschleife, die einen Teil der optischen Strahlung des Halbleiterlasers führt und in den Halbleiterlaser als Rücckoppelpulse zurückkoppelt, wobei der Halbleiterlaser ohne Beeinflussung durch die Rückkoppelpulse kammartige optische Pulse - nachfolgend Urpulse genannt - emittieren würde und im Falle einer Beeinflussung durch die Rückkoppelpulse beeinflusste kammartige Ausgangspulse emittiert, die einen geringeren zeitlichen Jitter bzw. ein geringeres Phasenrauschen als die Urpulse aufweisen.

Ein derartiger Oszillator für Urpulse ist aus der Druckschrift [10] bekannt. Mit diesem vorbekannten Oszillator lassen sich kammartige optische Ausgangspulse mit Jitterwerten im Pikosekundenbereich erreichen.

Ein Oszillator gemäß dem Oberbegriff der Ansprüche 1 und 9 ist zudem bekannt aus CHANG-YI LIN ET AL: "Microwave Characterization and Stabilization of Timing Jitter in a Quantum-Dot Passively Mode-Locked Laser via External Optical Feedback", IEEE JOURNAL OF SELECTED TOPICS IN QUANTUM ELECTRONICS, Bd. 17, Nr. 5, 1. September 2011, Seiten 1311-1317.

Elektrische Signale mit Frequenzen im Bereich zwischen 10 GHz und 100 GHz finden zunehmend Verwendung in der drahtlosen Kommunikation, bei hochauflösenden kurzreichweitigen Radaranlagen und als Taktgeber für Komponenten in optischen Kommunikationsnetzwerken. Neben der Leistung eines solchen elektrischen Signals ist die Stabilität in der Frequenzdomäne von äußerster Wichtigkeit für die praktische Anwendung [1]. Insbesondere die Verwendung als Taktgeber für die optische Datenkommunikation stellt hierbei neue Herausforderungen, da die Taktfrequenz des elektrischen Signals exakt mit der Bitrate des optischen Signals übereinstimmen muss. Zudem ist ein Trend hin zu stärkerer optischer Integration zu beobachten, so dass zusätzlich zum elektrischen Signal ein optisches Taktsignal gleicher Frequenz benötigt wird [2].

Als Quelle für ein optisches Taktsignal bietet sich auf Grund kleiner Abmessungen (Fläche des Chips ca. 0,3 $mm^2$), thermischer und physikalischer Stabilität sowie geringer Kosten ein monolithisch integrierter modengekoppelter Halbleiterlaser an. Dieser besteht aus einer Laserdiode, deren Wellenleiter in zwei elektrisch voneinander getrennte Sektionen unterteilt ist. Dies sind die Gewinn- und die Absorbersektion [3]. An den Teil des modengekoppelten Lasers (engl. mode-locked Laser / nachfolgend MLL genannt), der die Gewinnsektion bildet, wird eine Vorwärtsspannung angelegt, so dass ein konstanter Strom über die Diode fließt. Damit kommt es in diesem Teil der Laserdiode oberhalb der Laserschwelle zu einem Nettogewinn und es entsteht Laserlicht. Im Bereich der Absorbersektion wird die Diode in Sperrrichtung geschaltet, also eine negative Spannung $U_r$ angelegt. Die in der Gewinnsektion erzeugten Photonen, die in dieser Absorbersektion absorbiert werden, regen ein Elektron-Loch-Paar an. Da dadurch für kurze Zeit weniger Zustände für weitere Absorptionsprozesse zur Verfügung stehen, nimmt die Absorptionswahrscheinlichkeit ab. Der Absorber ist also über Photonenabsorption sättigbar und wird bei hinreichend starker Anregung transparent. Durch die angelegte Sperrspannung werden nun die angeregten Elektron-Loch-Paare getrennt. Damit stehen diese Zustände nach einer gewissen Zeit, der Erholzeit des Absorbers, wieder für weitere Absorptionsvorgänge zur Verfügung. Der durch die getrennten Elektron-Loch-Paare erzeugte Photostrom führt, so er denn moduliert ist, zu einer Modulation des elektrischen Widerstands der Absorbersektion [4], [5].

Die Kopplung der Verstärkung in der Gewinnsektion mit der sättigbaren Absorption führt über den Prozess der Modenkopplung zur Ausbildung von Pulsen in der Kavität. Bei fundamentaler Modenkopplung läuft nach der Einschwingzeit ein einzelner Puls in der Kavität um. Damit ist die Repetitionsrate $f_{MLL}$ direkt durch die Länge der Laserdiode gegeben:

$$f_{MLL} = \frac{v_{Gr}}{c} = \frac{c}{n - \lambda \frac{\partial n}{\partial \lambda}} \frac{1}{L}$$

Hierbei bezeichnet L die Länge der MLL-Kavität, n den Brechungsindex der MLL-Kavität, $v_{Gr}$ die Gruppengeschwindigkeit in der MLL-Kavität, $\lambda$ die Wellenlänge und c die Phasengeschwindigkeit des Lichts im Vakuum.

Wird, wie oben beschrieben, eine konstante Spannung an die Absorbersektion angelegt, spricht man von passiver Modenkopplung. Der Vorteil dieser Betriebsart liegt darin, dass kein externes elektrisches Hochfrequenzsignal bereitgestellt werden muss. Dies macht es möglich, einen solchen Betrieb zu geringen Kosten zu realisieren. Allerdings ist die Verwendbarkeit der so erzeugten Pulszüge als optisches Taktsignal eingeschränkt, da die stochastische Natur der spontanen Emission zu großen Schwankungen des Pulsabstands und der -amplitude führt.

Dieser Nachteil wird üblicherweise durch die sogenannte hybride Modenkopplung ausgeglichen. Hierbei wird zusätzlich zur konstanten Spannung am Absorber ein stabilisierendes, externes, hochfrequentes Spannungssignal angelegt. Durch diese Referenzfrequenz kann das Phasenrauschen des emittierten Pulszugs bei hinreichend hohen Leistungen des externen Signals entscheidend verringert werden. Da die Frequenz des externen Signals allerdings nahe (Abstand max. einige MHz) an der Repetitionsrate $f_{MLL}$ des vom MLL emittierten Pulszugs liegen muss, ist hierfür wiederum ein hochfrequentes und rauscharmes elektrisches Signal unabdingbar [6]. Da die Impedanz einer Laserdiode typischerweise nicht der Impedanz von elektrischen Hochfrequenzsystemen (50 Ω) entspricht, muss die elektrische Leistung des Hochfrequenzsignals zudem groß sein (≥ 14 dBm), was die Kosten für einen solchen Betrieb in die Höhe treibt.

Zur Zeit wird die gleichzeitige Bereitstellung rauscharmer optischer und elektrischer Signale im GHz-Bereich mit optoelektronischen Oszillatoren realisiert, die aus einem Dauerstrichlaser, einem Modulator, einer Photodiode, einem elektrischen Filter sowie einem oder mehreren elektrischen Verstärkern bestehen. Bei dieser Bauart erfolgt die Rückkopplung nicht, wie im Folgenden gezeigt, optisch, sondern durch ein elektrisches Signal am Modulator. Der Nachteil gegenüber dem hier gezeigten Bauelement ist allerdings, dass für die elektrische Rückkopplung aktive Bauelemente benötigt werden. Insbesondere die Verwendung eines Modulators, die hohe Eingangsleistungen des elektrischen Signals erfordert und folglich nur mit Hilfe von elektrischen Verstärkern gewährleistet werden kann, schlägt sich im Hinblick auf die Wirtschaftlichkeit negativ nieder. Durch die Nutzung aktiver elektronischer Komponenten ist die maximale Repetitionsrate beschränkt und die Produktionskosten sind hoch. [7], [8], [9].

Ausgehend von dem oben skizzierten Stand der Technik, insbesondere ausgehend von der Druckschrift [10], liegt der Erfindung die Aufgabe zugrunde, einen Oszillator anzugeben, mit dem sich Ausgangspulse mit besonders geringem Jitter erzeugen lassen.

Diese Aufgabe wird erfindungsgemäß durch einen Oszillator mit den Merkmalen gemäß Patentanspruch 1 gelöst. Vorteilhafte Ausgestaltungen des erfindungsgemäßen Oszillators sind in Unteransprüchen angegeben.

Danach ist erfindungsgemäß vorgesehen, dass die Dämpfung der Rückkopplungsschleife zwischen 27,5 und 37,5 dB beträgt und der Zeitversatz der Rückkopplungsschleife derart gewählt ist, dass jeder Rückkoppelpuls innerhalb der zeitlichen Halbwertsbreite eines nachfolgenden Urpulses, den der Halbleiterlaser ohne Beeinflussung durch den eintreffenden Rückkoppelpuls erzeugt hätte, eintrifft und die Länge der Rückkopplungsschleife derart gewählt ist, dass 6000 bis 7000 optische Pulse in ihr umlaufen.

Ein wesentlicher Vorteil des erfindungsgemäßen Oszillators ist darin zu sehen, dass sich mit diesem aufgrund des erfindungsgemäß vorgesehenen Parameterbereichs hinsichtlich der Dämpfung der Rückkopplungsschleife und des Zeitversatzes zwischen den Rückkoppelpulsen und den Urpulsen Werte für den integrierten Jitter im Bereich von 219 Femtosekunden oder weniger erreichen lassen, also Jitterwerte, die um den Faktor 5 kleiner sind als bei den besten vorbekannten Oszillatoren (vgl. Jitterwert von 1 Pikosekunde bei dem Oszillator gemäß [10]).

Vorzugsweise ist der Zeitversatz der Rückkopplungsschleife derart gewählt, dass die Pulsspitzenleistung eines jeden Rückkoppelpulses innerhalb der zeitlichen Halbwertsbreite eines nachfolgenden Urpulses eintrifft.

Der aktive Bereich des Halbleiterlasers weist vorzugsweise eine Doppelheterostruktur oder eine Fünffachstruktur mit getrennter Lokalisation von Ladungsträgern und Photonen, mit Quantentöpfen, Quantendrähten und/oder Quantenpunkten auf.

Der aktive Bereich ist bevorzugt in einer pn-Laserstruktur bestehend aus p- und n-dotierten Mantelschichten und hochdotierten Kontaktschichten eingebettet.

Der Halbleiterlaser ist vorzugsweise hochfrequenztauglich aufgrund planarisierender und isolierender BCB- (Benzocyclobuten), SiN- (Siliziumnitrid) oder SOG- (spin on glass) Zwischenschichten und einer Mehrfachschichtmetallisierung.

Vorteilhaft ist es, wenn die Kontaktierung der Absorbersektion des Halbleiterlasers und die Extraktion der elektrischen Pulse des Halbleiterlasers hochfrequenzfähig ist, aufgrund von Hochfrequenzabnehmern in Form eines Tastkopfes und Bonddrähten, eines Hochfrequenz-Bias-T und/oder von Hochfrequenzleitungen, welche beispielsweise planar sind.

Die Impedanz des Halbleiterlasers ist bevorzugt an die Impedanz von Signalabnehmern angepasst.

Die Facette der Absorbersektion ist bevorzugt hochreflektierend.

Die Lichtleitung in der optischen Rückkopplungsschleife basiert vorzugsweise auf Freistrahloptik und/oder Lichtwellenleitern (z. B. Glasfasern).

Die Rückkopplungsschleife reflektiert vorzugsweise einen konstanten oder variablen Teil der Strahlung des Halbleiterlasers.

Die Länge der Rückkopplungsschleife kann konstant oder variabel sein.

Die optische Rückkopplung führt vorzugsweise zu einer Rauschunterdrückung im optischen und/oder elektrischen Signal.

Auch ist es vorteilhaft, wenn in einer Kavität des Halbleiterlasers umlaufende Pulse zu einer Modulation des Photostroms an der Absorbersektion führen.

Der modulierte Photostrom ist vorzugsweise über hochfrequenzfähige Kontaktierung der Absorbersektion messtechnisch zugänglich.

Vorzugsweise überträgt sich die Rauschunterdrückung durch die optische Rückkopplung auf eine entsprechende Rauschunterdrückung der Modulation des elektrischen Signals.

Vorzugsweise werden ausgangsseitig sowohl elektrische als auch optische Pulse ausgegeben. Alternativ können ausgangsseitig auch nur optische oder nur elektrische Pulse ausgegeben werden.

Um ausgangsseitig einen elektrischen Pulskamm zu erzeugen, wird es als vorteilhaft angesehen, wenn an den monolithisch integrierten modengekoppelten Halbleiterlaser elektrisch ein Bias-T angeschlossen ist, mit dem elektrische Pulse ausgekoppelt werden, die in ihrer Frequenz den von den Rückkoppelpulsen beeinflussten optischen Ausgangspulsen des Halbleiterlasers entsprechen.

Besonders vorteilhaft ist es, wenn der Halbleiterlaser eine mit Vorwärtsspannung beaufschlagbare Gewinnsektion und eine, mit einer Rückwärtsspannung beaufschlagbare Absorbersektion umfasst und das Bias-T elektrisch an die Absorbersektion angeschlossen ist.

Vorzugsweise ist das Bias-T mit der Rückwärtsspannung und dem modulierten Photostrom der Absorbersektion beaufschlagt.

Als besonders vorteilhaft wird es angesehen, wenn ein Anschluss des Bias-T einen elektrischen Ausgang zur Ausgabe elektrischer Pulse bildet, deren Pulsverlauf dem Pulsverlauf der durch die Rückkoppelpulse der Rückkopplungsschleife beeinflussten optischen Pulse des Halbleiterlasers entspricht oder mit diesen identisch ist.

Durch die relative Verzögerung ist die Repetitionsfrequenz vorzugsweise innerhalb einiger MHz einstellbar. Vorzugsweise liegt die Länge der Rückkopplungsschleife zwischen 30 m und 34 m.

Die Erfindung bezieht sich außerdem auf ein Verfahren zum Erzeugen eines optischen und/oder elektrischen Pulskammes mittels eines optoelektronischen Oszillators mit einem monolithisch integrierten modengekoppelten Halbleiterlaser und einer optischen Rückkopplungsschleife, die einen Teil der optischen Strahlung des Halbleiterlasers reflektiert und in den Halbleiterlaser als Rückkoppelpulse zurückkoppelt, wobei der Halbleiterlaser ohne Beeinflussung durch die Rückkoppelpulse kammartig optische Pulse - nachfolgend Urpulse genannt - emittieren würde und im Falle einer Beeinflussung durch die Rückkoppelpulse der Rückkopplungsschleife beeinflusste, kammartige Pulse emittiert.

Erfindungsgemäß ist diesbezüglich vorgesehen, dass die Dämpfung der Rückkopplungsschleife auf einen Wert zwischen 27,5 und 37,5 dB eingestellt wird und der Zeitversatz der Rückkopplungsschleife derart eingestellt wird, dass jeder Rückkoppelpuls innerhalb der zeitlichen Halbwertsbreite eines nachfolgenden Urpulses eintrifft, den der Halbleiterlaser ohne Beeinflussung durch den eintreffenden Rückkoppelpuls erzeugt hätte und die Länge der Rückkopplungsschleife derart gewählt wird, dass 6000 bis 7000 optische Pulse in ihr umlaufen.

Bezüglich der Vorteile des erfindungsgemäßen Verfahrens sei auf die obigen Ausführungen im Zusammenhang mit dem erfindungsgemäßen Oszillator verwiesen.

Die Erfindung wird nachfolgend anhand von Ausführungsbeispielen näher erläutert; dabei zeigen beispielhaft:

Figur 1     ein Ausführungsbeispiel für einen optoelektronischen Oszillator zur Erzeugung eines optischen und elektrischen Pulskammes,

Figur 2     beispielhaft die Eigenschaften des Spektrums des vom Oszillator gemäß Figur 1 emittierten Pulszugs mit und ohne optische Rückkopplung sowie die erzielte Stabilisierung des Pulsabstands unter optischer Rückkopplung,

Figur 3     die Variation von Rückkopplungsdämpfung und relativer Verzögerung bei einer Rückkopplungslänge von 17 m,

Figur 4     die Eigenschaften des extrahierten Spannungssignals und der optischen Pulszüge, wobei der Abschnitt (a) das elektrische Spektrum und der Abschnitt (b) die Rauschleistungsdichte visualisiert, für den Fall ohne optischer Rückkopplung,

Figur 5     für den Fall mit optischer Rückkopplung die Eigenschaften des Spektrums des aus der Absorbersektion des Lasers des Oszillators gemäß Figur 1 extrahierten elektrischen Signals (Abschnitt (a) und (c)), sowie der Vergleich der Rauschleistungsdichten des optischen und des extrahierten elektrischen Signals in Abschnitt (b),

Figur 6     den integrierten Jitter bei einer Rückkopplungsdämpfung von 35 dB in Abhängigkeit von der Rückkopplungslänge zwischen 17 m und 73 m und der relativen Verzögerung,

Figur 7     den integrierten Jitter in Abhängigkeit von der Rückkopplungsdämpfung und der relativen Verzögerung bei einer Rückkopplungslänge von 32 m,

Figur 8     den integrierten Jitter in Abhängigkeit von der Rückkopplungsdämpfung,

Figur 9    den integrierten Jitter bei einer Rückkopplungslänge von 32 m und einer Rückkopplungsstärke von 29 dB in Abhängigkeit von der relativen Verzögerung und

Figur 10    beispielhaft einen zurückgekoppelten Puls und den zugehörigen Urpuls im zeitlichen Verlauf in schematischer Darstellung.

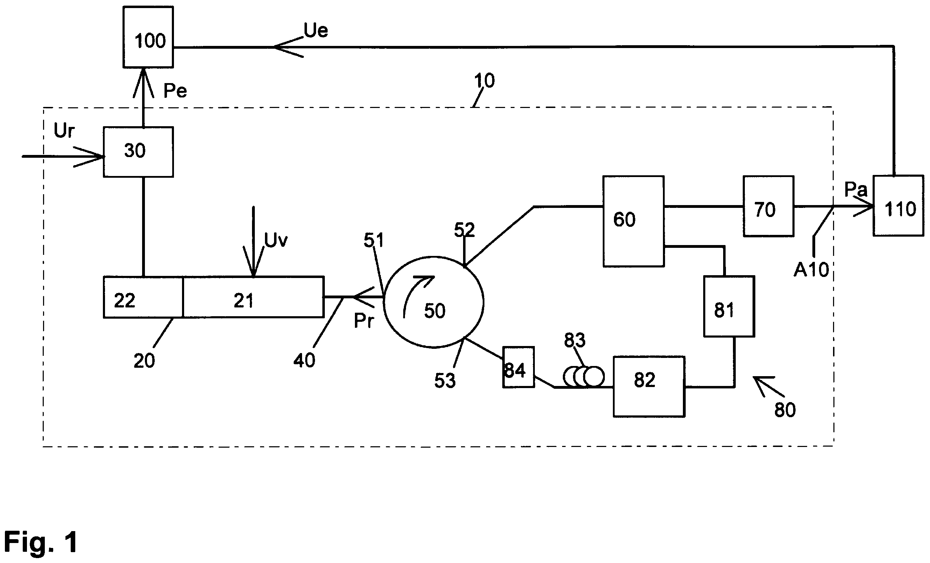

Die Figur 1 zeigt ein Ausführungsbeispiel für einen optoelektronischen Oszillator 10 zur Erzeugung eines optischen und elektrischen Pulskammes.

Der optoelektronische Oszillator 10 weist einen monolithisch integrierten passiv modengekoppelten Halbleiterlaser 20 - nachfolgend auch kurz MLL genannt - auf. Der Halbleiterlaser 20 umfasst eine Gewinnsektion 21, an der eine Vorwärtsspannung $U_v$ angelegt ist, und eine (vorzugsweise sättigbare) Absorbersektion 22, an der über ein Bias-T 30 eine Rückwärtsspannung $U_r$ angelegt ist.

Der optoelektronische Oszillator 10 weist außerdem eine Einkoppelglasfaser 40, einen Zirkulator 50, einen Leistungsteiler 60, einen Isolator 70 und eine optische Rückkopplungsschleife 80 auf, die einen Teil der optischen Strahlung des Halbleiterlasers führt und in den Halbleiterlaser 20 als Rückkoppelpulse $P_r$ zurückkoppelt. Der nicht zurückgekoppelte Teil der optischen Strahlung wird in Form optischer Ausgangspulse $P_a$ am Ausgang A10 des Oszillators bzw. am Ausgang des Isolators 70 ausgekoppelt.

Bei dem Ausführungsbeispiel gemäß Figur 1 kann die Spannungsmodulation auf Grund des Photostroms in der Absorbersektion 22 mit Hilfe des Bias-T 30 von der angelegten Rückwärtsspannung $U_r$ getrennt werden. Das so extrahierte Hochfrequenzsignal steht somit als elektrisches Signal, das aus kammartigen elektrischen Pulsen $P_e$ besteht, zusätzlich zu den optischen Ausgangspulsen $P_a$ des Oszillators 10 zur Verfügung. Die kammartigen elektrischen Pulse $P_e$ können beispielsweise mit Hilfe eines externen elektrischen Spektrumanalysators 100 - nachfolgend kurz ESA genannt - charakterisiert werden.

Die Einkoppelglasfaser 40, die mit der Gewinnsektionsfacette des MLL 20 verbunden ist bzw. zu der Gewinnsektionsfacette des MLL 20 im Brennweitenabstand positioniert ist, leitet das Licht des MLL 20 zu einem Tor 51 des optischen Zirkulators 50; den Zirkulator 50 verlässt das Licht an dessen Tor 52. Beispielsweise 90% der Intensität des Lichtes werden durch den Leistungsteiler 60 für die Nutzung in Form der optischen Ausgangspule Pa zur Verfügung gestellt, wohingegen 10% zu der Rückkopplungsschleife 80 gelangen.

Die Rückkopplungsschleife 80 weist vorzugsweise einen variablen Abschwächer 81 zur Kontrolle der Stärke der optischen Rückkopplung (einstellbare Dämpfung zwischen 2 dB und 60 dB), eine variable Verzögerungsstrecke 82 (einstellbare Verzögerung vorzugsweise über eine Periodendauer der Repetitionsrate von hier beispielsweise 25,9 ps), eine zusätzliche Faserstrecke 83 veränderlicher Länge und einen Polarisationssteller 84 auf.

Das Licht gelangt über das Tor 53 des optischen Zirkulators 50 auf das Tor 51 des selbigen und wird von dort wieder über die Gewinnsektionsfacette in den MLL 20 eingekoppelt.

Optische Rückkopplung

In einem ersten Schritt wurde erfinderseitig gezeigt, dass die optische Rückkopplung zu einer Stabilisierung des Pulsabstands, d. h. einer Reduktion des Phasenrauschens und damit des Zeitjitters, führen kann. Dies ist an sich bereits aus früheren Untersuchungen zu optischer Rückkopplung an MLLs bekannt [10].

Da optische Rückkopplung bei vielen Rückkopplungskonfigurationen auch zu einer Vergrößerung des Zeitjitters führen kann, wurden nun erstmalig die freien Parameter exakt bestimmt. Eine exakte Einstellung der Rückkopplungslänge über die optische Verzögerungsstrecke (mit einer Auflösung von 0,1 ps) sowie der Rückkopplungsstärke über den variablen Abschwächer (mit einer Auflösung von 0.01 dB) ist notwendig. Erst dadurch konnten die Rückkopplungsparameter so eingestellt werden, dass der Zeitjitter minimal ist.

Für folgende weiterführende Messungen wurden die vom Oszillator 10 emittierten Ausgangspulse $P_a$ mit Hilfe einer externen Photodiode 110 detektiert und in ein Spannungssignal $U_e$ umgewandelt, welches durch den ESA 100 auf die enthaltenen Frequenzen untersucht wurde.

Im Idealfall von vollständig konstanten Pulsabständen und -amplituden wäre nur eine einzige Frequenz im ESA-Spektrum enthalten. Eine Schwankung des Pulsabstands führt zu einer Verteilung der im ESA-Spektrum enthaltenen Frequenzen und damit zu einer Verbreiterung der gemessenen Linie. Die Linienbreite $v$ ist demnach ein Maß für die Stabilität des Pulsabstands. Sie geht auch in die Definition des Puls-zu-Puls-Jitters $\sigma_{P\text{-}P}$ ein [11] :

$$\sigma_{P-P} = \sqrt{\frac{v}{2\pi f_{MLL}^3}} \qquad (1)$$

Daneben kann mit Hilfe des ESA auch die Rauschleistungsdichte $L_{Noise}$ des Signals bei einer bestimmten Rauschfrequenz $\Delta_f$ bestimmt werden. Diese berechnet sich aus dem Verhältnis zwischen der Signalleistung $L_{MLL}$ und der Rauschleistung bei der entsprechenden Rauschfrequenz $L(\Delta_f)$ [12]:

$$L_{Noise}(\Delta f) = \frac{L(\Delta f)}{L_{MLL}} \qquad\qquad (2)$$

Aus dieser kann der integrierte Jitter ermittelt werden, welchem im Wesentlichen gegeben ist durch die Integration über die Rauschleistungsdichte. Hierzu ist es notwendig, die Integrationsgrenzen festzulegen. Die obere Integrationsgrenze wurde hier auf 1 GHz festgelegt, während die untere 10 kHz beträgt.

$$\sigma_f^{RMS}(f_u, f_o) = \frac{1}{2\pi f_{Carrier}} \sqrt{2 \int_{f_u}^{f_o} d(\Delta f)\, L_{Noise}(\Delta f)}$$

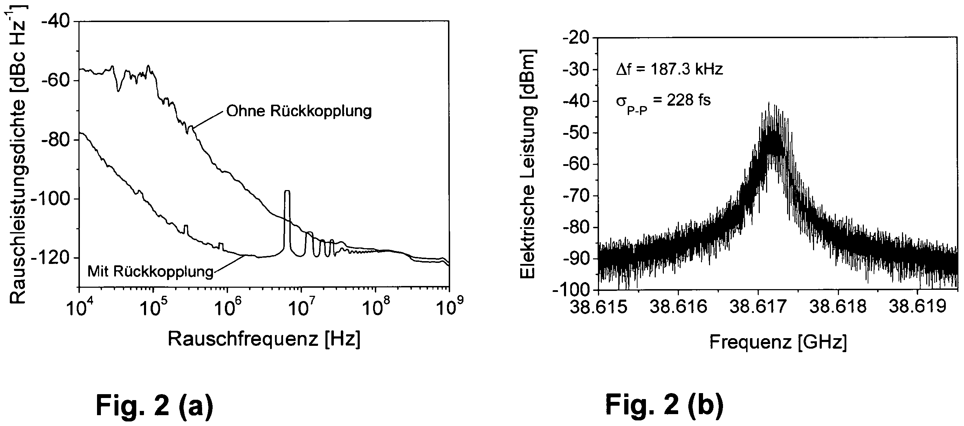

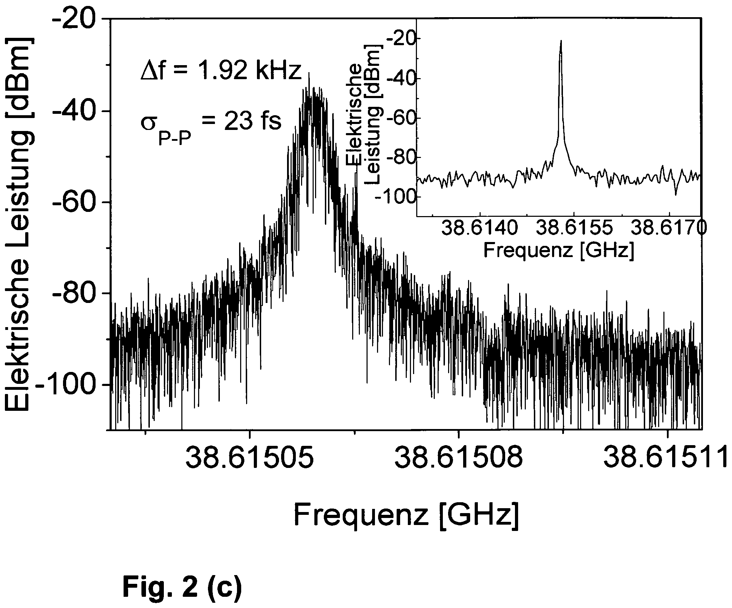

Die Figur 2 zeigt die Eigenschaften des ESA-Spektrums des vom MLL emittierten Pulszugs mit und ohne optische Rückkopplung sowie die erzielte Stabilisierung des Pulsabstands unter optischer Rückkopplung; dabei ist in Abschnitt (a) der Figur 2 die Rauschleistungsdichte mit und ohne optische Rückkopplung, in Abschnitt (b) der Figur 2 eine hochaufgelöste Messung der Linie im ESA-Spektrum ohne optische Rückkopplung und in Abschnitt (c) in Figur 2 eine hochaufgelöste Messung der Linie im ESA-Spektrum mit optischer Rückkopplung gezeigt.

Die Rauschleistungsdichte in Figur 2 (a) ist unter optischer Rückkopplung bei Rauschfrequenzen zwischen 10 kHz und 1 MHz um mindestens 20 dB (entsprechend auf unter 1%) verringert (im Vergleich zum Fall ohne optische Rückkopplung). Dadurch wird auch das Niveau des thermischen Rauschens des Messsystems früher erreicht (1 MHz anstatt 20 MHz). Solch niedrige Rauschleistungsdichten entsprechen einer Pulsemission mit einem sehr konstanten Pulsabstand.

Dieser Schluss lässt sich auch aus der Betrachtung der Linienbreite ziehen. Diese reduziert sich von 187,3 kHz ohne optische Rückkopplung um 99% auf 1,92 kHz unter optischer Rückkopplung. Der Puls-zu-Puls-Jitter verringert sich von 228 fs auf 23 fs.

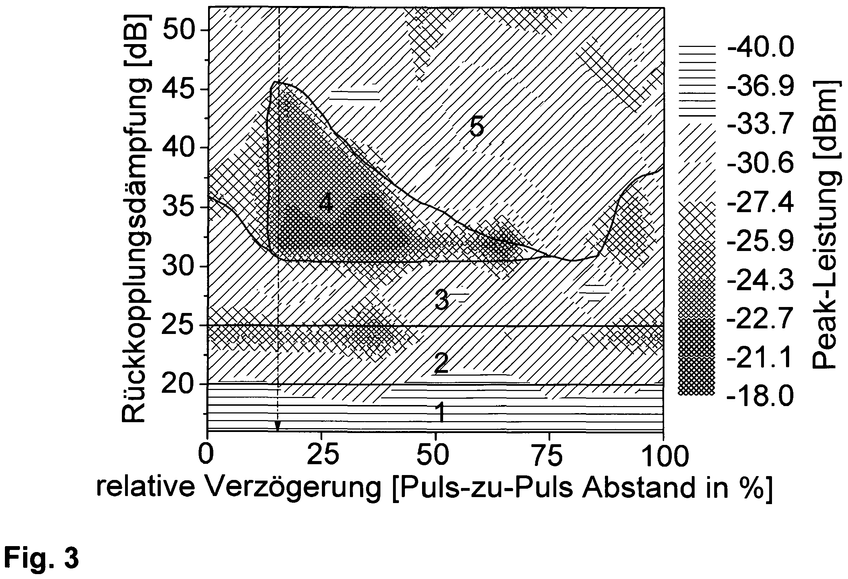

Mit Hilfe der hier vorgestellten exakten Kontrolle der Parameter der optischen Rückkopplung kann demnach der Pulsabstand im optischen Signal extrem effizient stabilisiert werden. Der aus den genannten Parametern resultierende Raum aller Rückkopplungskonfigurationen ist dreidimensional (Stärke der optischen Rückkopplung, relative Verzögerung und Faserlänge (Anzahl der Pulse in der Rückkopplungsschleife)). Bereits die Variation eines einzelnen Rückkopplungsparameters hat große Auswirkungen auf das Verhalten des Systems. Zunächst wurden Messungen für eine konstante Rückkopplungslänge von 16,6 m durchgeführt. Die relative Verzögerung wurde über den gesamten Bereich eines Puls-zu-Puls Abstandes variiert. Dies ist ausreichend, weil das Verhalten unter optischer Rückkopplung periodisch in der Verzögerung ist. Die Dämpfung in der Rückkopplungsschleife betrug zwischen 16 dB und 52 dB. Die Variation der beiden Parameter wirkt sich, wie in Figur 3 gezeigt, auf die Eigenschaften des elektrischen Spektrums und damit des integrierten Jitters aus.

Die Figur 3 zeigt die Variation von Rückkopplungsdämpfung und relativer Verzögerung bei einer Rückkopplungslänge von 16,6 m. In der Figur 3 sind fünf Bereiche eingezeichnet, in denen die optische Rückkopplung unterschiedlichen Einfluss auf die Pulsemission des MLLs hat. Diese Bereiche lassen sich an Hand der ESA- und Autokorrelationsmessungen identifizieren und werden im Folgenden näher klassifiziert.

Der Bereich 1 liegt im Bereich der starken optischen Rücckopplung bei Dämpfungen bis 20 dB. Dort ist die Peak-Leistung im elektrischen Spektrum ca. 10 dB kleiner als im Fall ohne Rückkopplung. Die geringere Peak-Leistung ist darauf zurückzuführen, dass die Seitenbanden sehr stark ausgeprägt sind. Die Form des ungestörten ESA-Spektrums des MLL ist hier nicht mehr zu erkennen. Es lässt sich festhalten, dass die optische Rückkopplung im Bereich 1 den MLL so stark beeinflusst, dass sie sowohl die Eigenschaften des elektrischen, als auch die des optischen Spektrums dominiert. Da es in diesem Bereich zu einer Verschlechterung der Pulseigenschaften und zu einer Verstärkung hoher Rauschfrequenzen kommt, ist es nicht wünschenswert, einen MLL bei zu starker optischer Rückkopplung zu betreiben.

Der Bereich 2 der optischen Rückkopplung ist durch den Übergang vom dominierenden Einfluss der Rückkopplung im Bereich 1 hin zum im Folgenden beschriebenen Bereich 3 geprägt. Der Übergang erfolgt chaotisch, was sich in Sprüngen zwischen beiden Bereichen ausdrückt.

Bei Rückkopplungsdämpfungen über 25 dB schließt sich der Bereich 3 an. Hier beginnt sich die Lorentzform des Peaks im elektrischen Spektrum durchzusetzen. Dessen Breite hat jedoch zur Folge, dass der Verlauf der Rauschleistungsdichte im Bereich des Abfalls um 20 dB pro Dekade um 12 dB höher ist als ohne Rückkopplung. Analog zum Bereich 1 führen die immer noch starken Seitenbanden dazu, dass die Rauschleistungsdichte nicht ins thermische Rauschen übergeht. Auch im Bereich 3 der optischen Rückkopplung tritt also eine, wenn auch nicht so starke, Verschlechterung der Eigenschaften der Pulsemission des MLL auf.

Ein völlig anderes Bild ergibt sich hingegen im Bereich 4. Dieser Bereich beginnt bei Rückkopplungsdämpfungen über 30 dB, und seine Ausdehnung in Richtung der relativen Verzögerung ist abhängig von der Rückkopplungsstärke. Es zeigt sich eine starke Verringerung der Linienbreite im elektrischen Spektrum sowie eine große Unterdrückung der Seitenbanden um mindestens 49 dB. Durch die große Unterdrückung sind lediglich vier Seitenbanden oberhalb des Rauschniveaus des Messsystems zu erkennen. ESA-Spektren deuten auf eine sehr stabile Pulsemission in diesem Bereich der optischen Rückkopplung hin. Die Grenze des Plateaus des weißen Rauschens liegt bei Frequenzen kleiner als 10 kHz. Dadurch tritt die Abnahme um 20 dB pro Dekade bereits früher ein, und die begrenzende thermische Rauschleistungsdichte des Messsystems wird schon bei 2 MHz erreicht. Durch die Stabilisierung des Pulsabstands bei gleichbleibender Pulsqualität ist es bei der Verwendung von optischer Rückkopplung erstrebenswert, in diesem Bereich zu arbeiten. Bei einer Rückkopplung in diesem Bereich schieben sich die Urpulse immer automatisch auf die rückgekoppelten Pulse, und zwar für alle Verzögerungen zwischen etwa 15 und 65 %, d. h. $\Delta t$ zwischen Ur- und Rückkopplungspulsen ist immer null. Die Pulse sind also miteinander verklammert. In diesem Bereich wird die Erzeugung der Urpulse durch die rückgekoppelten Pulse derart zeitlich verschoben, dass sie nach Einstellung des Gleichgewichts zusammenfallen. Zu einem Zeitpunkt kurz vor der Urpulsemission ohne Rückkopplung (vertikaler Pfeil) reichen daher auch sehr schwache Rückkopplungsstärken aus, um resonantes Lasing zu erreichen. Wenn man die rückgekoppelten Pulse von diesem Zeitpunkt wegschiebt (in Richtung 50, 60%), funktioniert dies nicht mehr mit kleinen Leistungen.

Außerhalb des Bereichs 4 und oberhalb von Rückkopplungsdämpfungen von 30 dB bis 35 dB befindet sich schließlich der Bereich 5 der optischen Rückkopplung. Im Bereich 5 ist das optische Spektrum dasselbe wie im Fall ohne Rückkopplung, und das elektrische Spektrum zeigt die bereits bekannte Lorentzform. Allerdings erhöht sich die Breite des Lorentzprofils abhängig von den Rückkopplungsparametern in diesem Bereich ohne erkennbares Muster. Der Einfluss der optischen Rückkopplung ist dort demnach nicht stark genug, um die Pulsemission wie im Bereich 4 zu stabilisieren. Vielmehr kann es zu Störungen der Pulsemission kommen.

Extraktion eines elektrischen Signals

Wie oben ausgeführt wurde, führen die in der Kavität eines MLL umlaufenden Pulse zu einer Modulation des Photostroms und diese wiederum zu einer Modulation der an der Absorbersektion angelegten Spannung. In dem Aufbau gemäß Figur 1 ist diese Spannungsmodulation zugänglich und kann technisch genutzt werden.

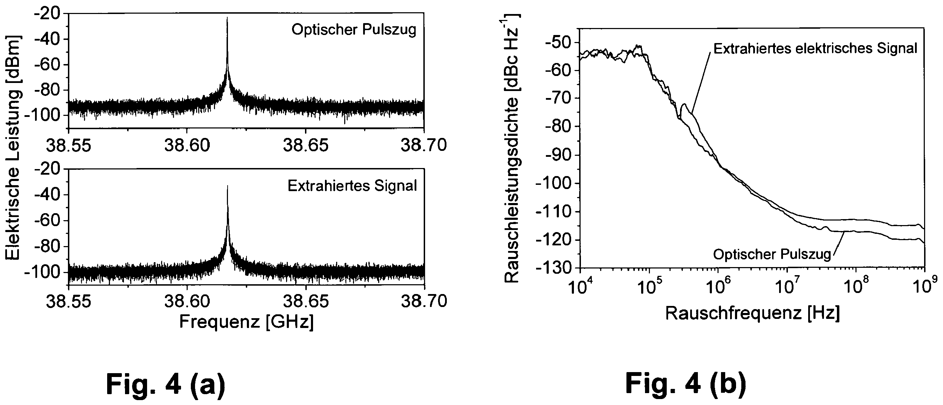

Die Figur 4 zeigt den Vergleich der Eigenschaften des extrahierten Spannungssignals sowie der optischen Pulszüge, wobei der Abschnitt (a) das ESA-Spektrum und der Abschnitt (b) die Rauschleistungsdichte visualisiert. Wie aus Figur 4 hervorgeht, sind die Eigenschaften des elektrischen Spektrums nahezu unabhängig davon, ob das optische Signaloder das extrahierte elektrische Signal betrachtet wird.

Damit ist gezeigt, dass die Ladungsträgerdynamik in der Absorbersektion in der Lage ist, der Modulation der Elektron-Loch-Paar-Erzeugung durch den Pulsumlauf zu folgen. Dieser Umstand bildet die Grundlage für die Erzeugung stabiler elektrischer Signale mit Hilfe des Oszillators gemäß Figur 1.

Kombinierte Erzeugung von stabilen elektrischen und optischen Signalen:

Wie oben dargelegt, übertragen sich die Rauscheigenschaften des optischen Pulszuges direkt auf das Spannungssignal an der Absorbersektion. Der in Figur 1 gezeigte Oszillator verknüpft die mit der optischen Rückkopplung einhergehende Stabilisierung des Pulsabstands im optischen Signal mit der Erzeugung eines frequenzstabilen elektrischen Signals:

1. Die optische Rückkopplung verringert die Schwankungen des Pulsabstands in der MLL-Kavität.
2. Dies führt zu einer Verringerung des Puls-zu-Puls-Jitters um 90% im emittierten optischen Pulszug im Vergleich zum Fall ohne optische Rückkopplung.
3. Der in der Kavität umlaufende Puls führt zu einer Modulation des Photostroms in der Absorbersektion.
4. Die Modulation des Photostroms führt zu einer Modulation der über der Absorbersektion der Laserdiode abfallenden Spannung.
5. Die Rauscheigenschaften des durch diese Modulation entstehenden Signals entsprechen weitgehend denen des optischen Signals. Damit ist auch das Phasenrauschen des elektrischen Signals durch die optische Rückkopplung unterdrückt.

Die prinzipielle Funktionsweise konnte mit dem in Figur 1 gezeigten Oszillator nachvollzogen werden.

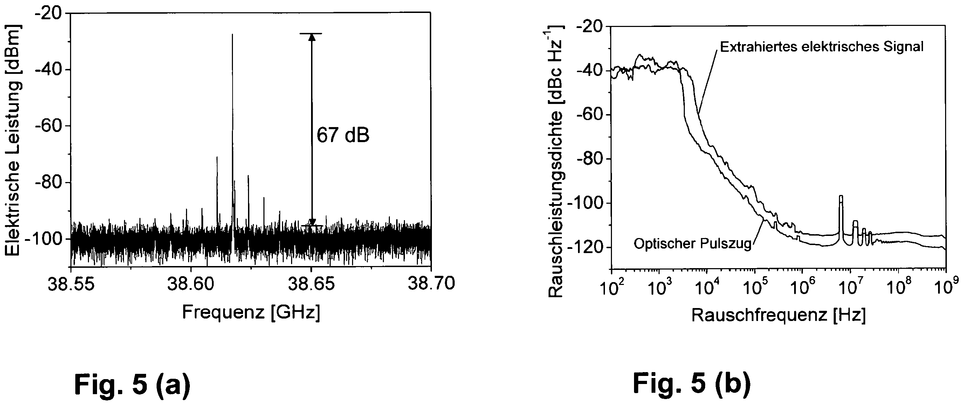

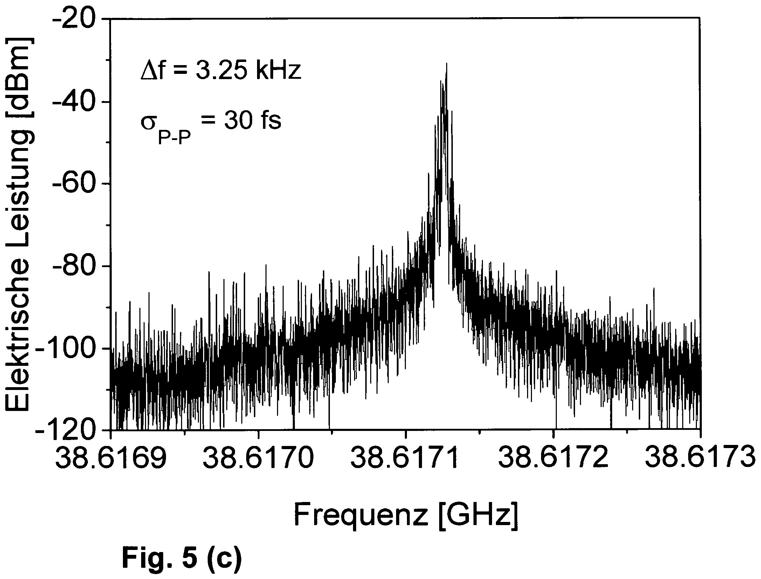

Die Figur 5 zeigt die Eigenschaften des ESA-Spektrums des aus der Absorbersektion des MLL extrahierten elektrischen Signals; dabei ist in Abschnitt (a) ein ESA-Spektrum des elektrischen Signals in weitem Frequenzintervall, in Abschnitt (b) die Rauschleistungsdichte des extrahierten elektrischen und des optischen Signals und in Abschnitt (c) eine hochaufgelöste Messung der zentralen Linie im ESA-Spektrum des elektrischen Signals gezeigt.

Der Signal-zu-Rausch-Abstand im elektrischen Spektrum beträgt 67 dB, und der Abstand der im ESA-Spektrum sichtbaren Seitenbanden von der zentralen Linie entspricht der Eigenfrequenz der Rückkopplungsschleife. Wie gezeigt werden kann, entsprechen diese Seitenbanden einer kleinen Amplitudenmodulation (ca. 1% bis 2% der Pulsamplitude) und schränken die Verwendbarkeit des elektrischen Signals nicht ein. Die Breite der zentralen Linie beträgt nur 3,25 kHz und der Puls-zu-Puls-Jitter dieses elektrischen Signals ergibt sich zu 30 fs. Die Wiederholrate des elektrischen Signals stimmt mit derjenigen des optischen Signals überein.

Ein Vergleich der Rauschleistungsdichten von elektrischem und optischem Signal zeigt, dass das hier vorgestellte Bauelement in der Lage ist, gleichzeitig optische Pulszüge und ein elektrisches Signal hoher Qualität mit sehr geringem Phasenrauschen zu erzeugen.

Die entscheidenden Vorteile des vorgestellten Bauelements im Vergleich zu hybrider Modenkopplung sind:

- Es wird gleichzeitig ein optisches sowie ein elektrisches Hochfrequenzsignal höchster Qualität erzeugt.
- Es ist kein externes, hochfrequentes Spannungssignal notwendig. Damit ergeben sich Größen- und Kostenvorteile.

Die entscheidenden Vorteile des Oszillators 10 gemäß Figur 1 im Vergleich zu aktuellen optoelektronischen Oszillatoren sind:

- Die Repetitionsrate kann von einigen GHz bis hin zu mindestens 100 GHz reichen. Die einzige bestimmende Größe ist hierbei die Kavitätslänge des MLL.
- Es werden ausschließlich passive optische und elektrische Komponenten benötigt. Daher wird die Repetitionsrate des Systems nicht durch die Bandbreite aktiver elektronischer Komponenten begrenzt.
- Die passiven optischen und elektrischen Komponenten führen zu einem geringen Energieverbrauch sowie geringen Produktionskosten.

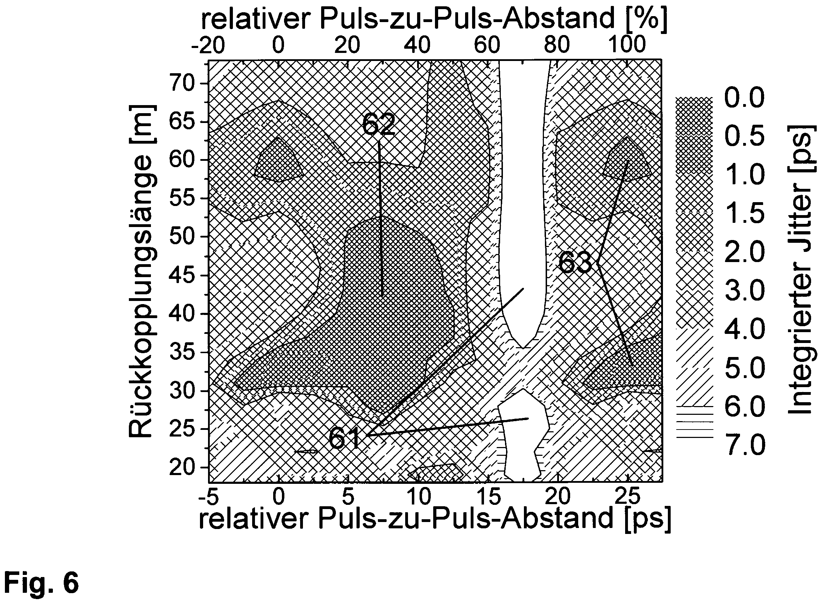

Im Zusammenhang mit den Figuren 6 bis 10 soll nochmals mit anderen Worten erläutert werden, mit welchen Schritten sich der optimale Parameterbereich für den Oszillator gemäß Figur 1 bestimmen lässt:
Die drei bestimmenden Parameter der optischen Rückkopplung sind

- die Rückkopplungsdämpfung,
- die relative Verzögerung und
- die Länge der Rückkopplungsschleife.

Diese Größen spannen einen dreidimensionalen Parameterraum auf und sind miteinander verknüpft.

Zuerst wird nachfolgend auf den Einfluss der Faserlänge eingegangen. Um den Einfluss der größeren Dämpfung bei längeren Faserstrecken zu eliminieren, wurde die Abschwächung jeweils so eingestellt, dass die Gesamtdämpfung in der Rückkopplungsschleife konstant 35 dB beträgt.

Längenabhängigkeit

Die Figur 6 zeigt den integrierten Jitter bei einer Rückkopplungsdämpfung von 35 dB in Abhängigkeit von der Rückkopplungslänge zwischen 17 m und 73 m und der relativen Verzögerung. Die relative Verzögerung wurde über einen Zeitbereich von 32,5 ps variiert, und somit über einen Zeitbereich der größer ist als die Periodendauer von 25,9 ps. Der integrierte Jitter variiert über knapp 2 Zehnerpotenzen. Der chaotische Bereich, in dem keine stabile Modenkopplung auftritt, ist weiß und mit dem Bezugszeichen 61 gekennzeichnet. Die Flächen 62 und 63 mit minimalem integrierten Jitter entsprechen dem Bereich der resonanten Rückkopplung. Diese hat ihre größte Ausdehnung bei einer Faserlänge von 32 m +/- 2m.

Abhängigkeit von Rückkopplungsdämpfung und relativer Verzögerung

Nun wurden für eine konstante Rückkopplungslänge von 32 m durch Variation der relativen Verzögerung und der Rückkopplungsdämpfung die Auswirkungen auf das Verhalten des Systems bestimmt. Die relative Verzögerung wurde über einem Bereich von über 30 ps variiert. Dies ist mehr als ausreichend, da das Verhalten unter optischer Rückkopplung periodisch in der Verzögerung ist und die Periode dem zeitlichen Abstand der Pulse des MLL entspricht (hier 25,9 ps). Die Dämpfung in der Rückkopplungsschleife variierte zwischen 16 dB und 52 dB. Die Variation der beiden Parameter wirkt sich wiederum enorm auf den integrierten Jitter aus.

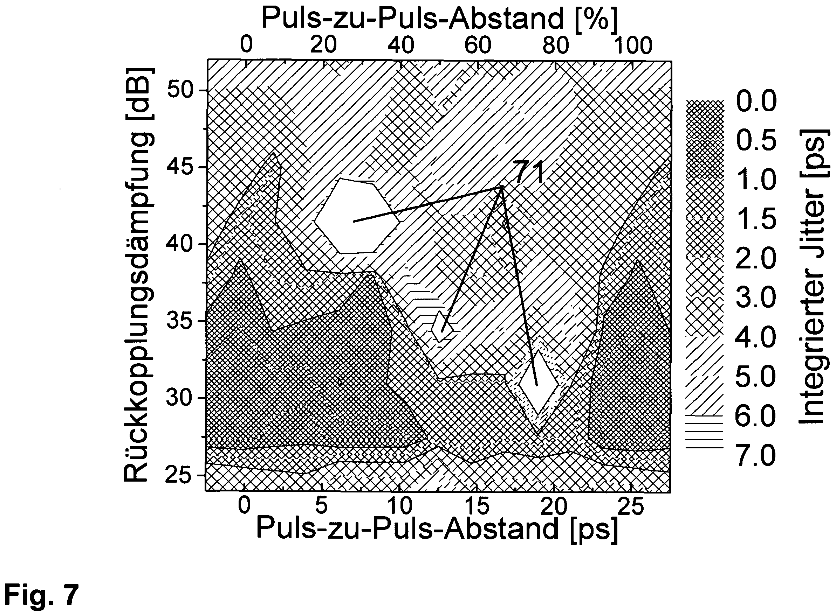

Die Figur 7 zeigt den integrierten Jitter in Abhängigkeit von der Rückkopplungsdämpfung und der relativen Verzögerung bei einer Rückkopplungslänge von 32 m. Die weißen Flächen 71 entsprechen Jitter über 7 ps.

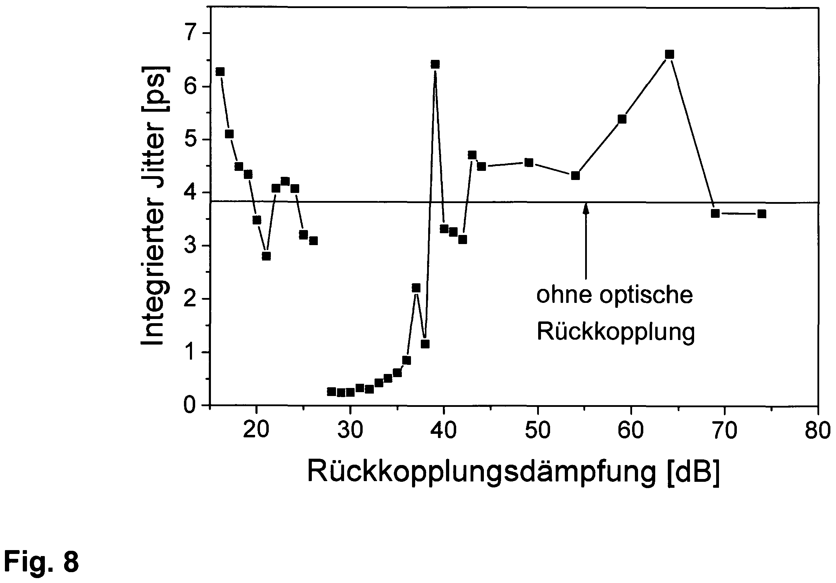

Die Figur 8 zeigt den integrierten Jitter in Abhängigkeit von der Rückkopplungsdämpfung. Wie man sieht, liegt die optimale Rückkopplungsdämpfung bei 29,5 dB +/- 2,5 dB. Der integrierte Jitter variiert wiederum über knapp 2 Zehnerpotenzen.

Abhängigkeit von relativer Verzögerung

Nach der Festlegung der optimalen Rückkopplungsdämpfung bei einem konstanten Wert dieses Parameters von 29 dB wird nun der Bereich der optimalen relativen Verzögerung bestimmt. Von - 3 ps bis 12 ps kommt es zu einer starken Verringerung des Rauschens, was einem integrierten Jitter bis 390 fs und damit einer Verringerung um mehr als einen Faktor 10 gegenüber dem Fall ohne Rückkopplung entspricht.

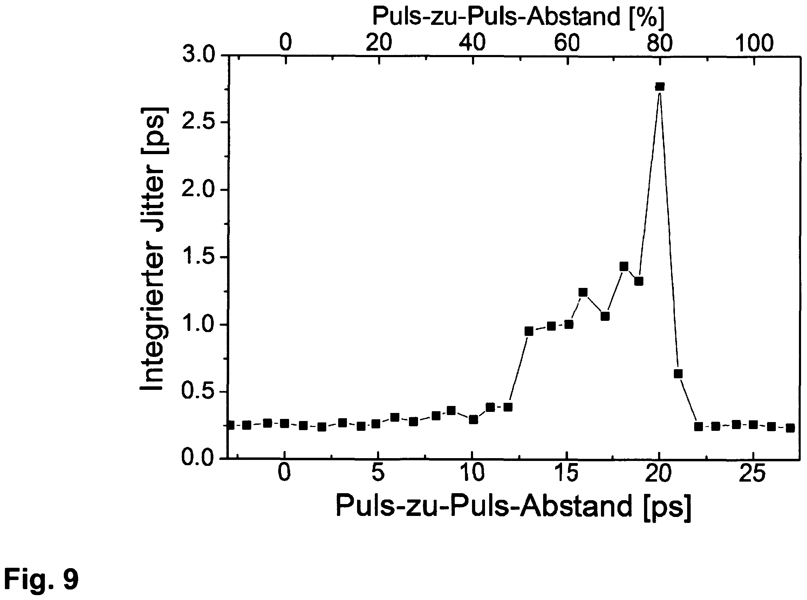

Die Figur 9 zeigt den integrierten Jitter bei einer Rückkopplungslänge von 32.7 m und einer Rückkopplungsstärke von 29 dB in Abhängigkeit von der relativen Verzögerung.

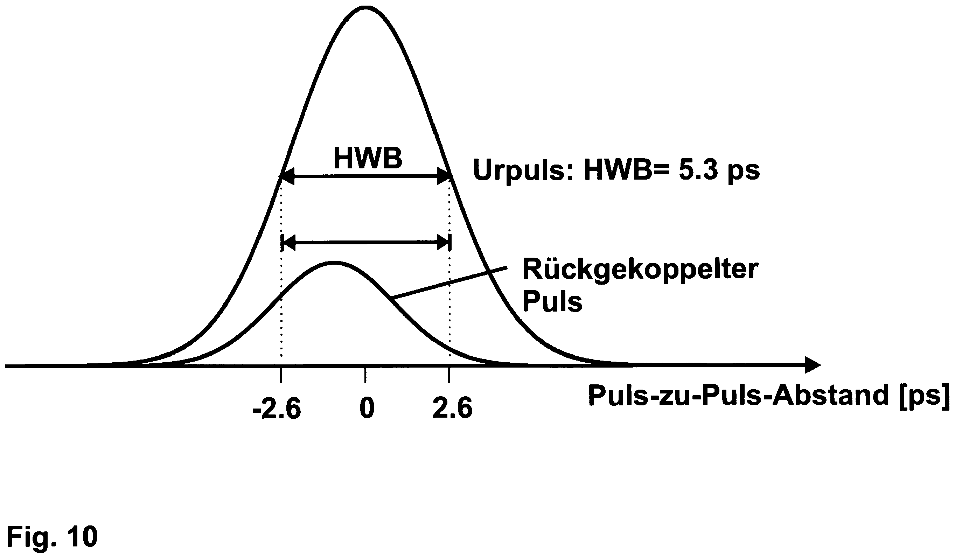

Für die resonante Rückkopplung, die eine Reduzierung des Jitters um einen Faktor 15 und größer hervorbringt, müssen jedoch die zurückgekoppelten Pulse, bezogen auf die Urpulse, innerhalb der optischen Halbwertsbreite der Urpulse auftreffen. Deren Halbwertsbreite beträgt hier 5.3 ps. Dies zeigt beispielhaft Figur 10.

Bei einer Rückkopplung in diesem Bereich schieben dann die Urpulse immer automatisch auf die rückgekoppelten Pulse (Clampingeffekt), und zwar für alle relativen Verzögerungen, die innerhalb der Halbwertsbreite der Urpulse liegen. Folglich ist $\Delta t$ real immer null und die Pulse sind miteinander verklammert.

Literatur

[1] L. Maleki, "The optoelectronic oscillator", Nature Photonics - Industry Perspective, pp. 728 - 730, Dezember 2011.

[2] S. K. Tewksbury und L. A. Hornak, "Optical Clock Distribution in Electronic Systems", Journal of VLSI Signal Processing, pp. 225 - 246, 1997.

[3] P. J. Delfyett, D. H. Hartmann und S. Z. Ahmad, "Optical Clock Distribution Using a Mode-Locked Semicondurctor Laser Diode System", Journal of Lightwave Technology, pp. 1646 - 1649, Dezember 1991.

[4] H. A. Haus, "Mode-locking of lasers", IEEE Journal of Selected Topics in Quantum Electronics, Bd. 6, Nr. 6, pp. 1173 - 1185, November 2000.

[5] D. Bimberg, "Quantum dot based nanophotonics and nanoelectronics", Electronics Letters, Bd. 44, Nr. 3, pp. 168 - 171, Januar 2008.

[6] M. Kuntz, G. Fiol, M. Lämmlin, C. Meuer und D. Bimberg, "High-Speed Mode-Locked Quantum-Dot Lasers and Optical Amplifiers", Proceedings of the IEEE, Bd. 95, Nr. 9, pp. 1767 - 1778, September 2007.

[7] J. Lasri, A. Bilenca, D. Dahan, V. Sidorov, G. Eisenstein, D. Ritter und K. Yvind, "A Self-Starting Hybrid Optoelectronic Oscillator Generating Ultra Low Jitter 10-GHz Optical Pulses and Low Phase Noise Electrical Signals", IEEE Photonics Technology Letters, pp. 1004 - 1006, Juli 2002.

[8] C. W. Nelson, A. Hati, D. A. Howe und W. Zhou, "Microwave Optoelectronic Oscillator with Optical Gain", National Institute of Standards and Technology (NIST), 2007.

[9] N. Yu, E. Salik und L. Maleki, "Ultralow-noise mode-locked laser with coupled optoelectronic oscillator configuration", Optics Letters, pp. 1231 - 1233, Mai 2005.

[10] G. Fiol, M. Kleinert, D. Arsenijevic und D. Bimberg, "1.3 $\mu$m range 40 GHz quantum-dot mode-locked laser under external continuous wave light injection or optical feedback", Semiconductor Science and Technology, Bd. 26, Nr. 1, p. 014006, November 2010.

[11] F. Kefelian, S. O'Donoghue, M. T. Todaro, J. G. McInerney und G. Huyet, "RF Linewidth in Monolithic Passively Mode-Locked Semiconductor Laser", IEEE Photonics Technology Letters, Bd. 20, Nr. 16, pp. 1405-1407, 15. August 2008.

[12] D. von der Linde, "Characterization of the Noise in Continuously Operating Mode-Locked Lasers", Applied Physics B, Bd. 39, pp. 201-207, 1986.

[13] G. Fiol, "1.3 µm Monolithic Mode-Locked Quantum-Dot Semiconductor Lasers", Berlin: Mensch und Buch Verlag, 2011.

[14] OEWaves Inc., "Micro-Opto-Electronic Oscillator (uOEO)", Pasadena, USA, 2012.

Bezugszeichen

| 10 | optoelektronischer Oszillator |
| 20 | Halbleiterlaser |
| 21 | Gewinnsektion |
| 22 | sättigbare Absorbersektion |
| 30 | Bias-T |
| 40 | Einkoppelglasfaser |
| 50 | Zirkulator |
| 51 | Tor des optischen Zirkulators |
| 52 | Tor des optischen Zirkulators |
| 53 | Tor des optischen Zirkulators |
| 60 | Leistungsteiler |
| 70 | Isolator |
| 80 | optische Rückkopplungsschleife |
| 81 | variabler Abschwächer |
| 82 | variable Verzögerungsstrecke |
| 83 | Faserstrecke |
| 84 | Polarisationssteller |
| 100 | externer Spektrumanalysator |
| 110 | Photodiode |
| | |
| A10 | Ausgang des Oszillators |
| Pa | Ausgangspuls |
| Pe | kammartiger elektrischer Puls |
| Pr | Rückkoppelpuls |
| Ue | Spannungssignal |
| Uv | Vorwärtsspannung |
| Ur | Rückwärtsspannung |

**Patentansprüche**

1. Optoelektronischer Oszillator (10) zur Erzeugung eines optischen und/oder elektrischen Pulskammes

   - mit einem monolithisch integrierten passiv modengekoppelten Halbleiterlaser (20) und
   - mit einer optischen Rückkopplungsschleife (80), die einen Teil der optischen Strahlung des Halbleiterlasers (20) führt und in den Halbleiterlaser (20) als Rückkoppelpulse (Pr) zurückkoppelt, wobei die Dämpfung der Rückkopplungsschleife (80) zwischen 27,5 und 37,5 dB beträgt, und
   - wobei der Halbleiterlaser (20) ohne Beeinflussung durch die Rückkoppelpulse (Pr) kammartige optische Pulse
   - nachfolgend Urpulse genannt - emittieren würde und im Falle einer Beeinflussung durch die Rückkoppelpulse (Pr) beeinflusste kammartige Ausgangspulse (Pa) emittiert, die einen geringeren zeitlichen Jitter bzw. ein geringeres Phasenrauschen als die Urpulse aufweisen,
   **dadurch gekennzeichnet, dass**
   - der Zeitversatz der Rückkopplungsschleife (80) derart gewählt ist, dass jeder Rückkoppelpuls (Pr) innerhalb der zeitlichen Halbwertsbreite eines nachfolgenden Urpulses, den der Halbleiterlaser (20) ohne Beeinflussung durch den eintreffenden Rückkoppelpuls (Pr) erzeugt hätte, eintrifft, und
   - die Länge der Rückkopplungsschleife (80) derart gewählt ist, dass 6000 bis 7000 optische Pulse in ihr umlaufen.

**2.** Optoelektronischer Oszillator (10) nach Anspruch 1, **dadurch gekennzeichnet, dass**
der Zeitversatz der Rückkopplungsschleife (80) derart gewählt ist, dass die Pulsspitzenleistung eines jeden Rückkoppelpulses (Pr) innerhalb der zeitlichen Halbwertsbreite eines nachfolgenden Urpulses eintrifft.

**3.** Optoelektronischer Oszillator (10) nach einem der voranstehenden Ansprüche,
**dadurch gekennzeichnet, dass**
an den monolithisch integrierten modengekoppelten Halbleiterlaser (20) elektrisch ein Bias-T (30) angeschlossen ist, mit dem elektrische Pulse ausgekoppelt werden, die in ihrer Frequenz den von den Rückkoppelpulsen (Pr) beeinflussten optischen Ausgangspulsen (Pa) des Halbleiterlasers (20) entsprechen.

**4.** Optoelektronischer Oszillator (10) nach Anspruch 3, **dadurch gekennzeichnet, dass**

- der Halbleiterlaser (20) eine mit Vorwärtsspannung (Uv) beaufschlagbare Gewinnsektion (21) und eine sättigbare, mit einer Rückwärtsspannung (Ur) beaufschlagbare Absorbersektion (22) umfasst und
- das Bias-T (30) elektrisch an die Absorbersektion (22) angeschlossen ist.

**5.** Optoelektronischer Oszillator (10) nach Anspruch 4,
**dadurch gekennzeichnet, dass**
das Bias-T (30) mit dem modulierten Photostrom der Absorbersektion (22) beaufschlagt ist.

**6.** Optoelektronischer Oszillator (10) nach Anspruch 4 oder 5,
**dadurch gekennzeichnet, dass**
ein Anschluss des Bias-T (30) einen elektrischen Ausgang zur Ausgabe elektrischer Pulse bildet, deren Pulsverlauf dem Pulsverlauf der durch die Rückkoppelpulse ($P_r$) der Rückkopplungsschleife (80) beeinflussten Ausgangspulse ($P_a$) entspricht oder mit diesen identisch ist.

**7.** Optoelektronischer Oszillator (10) nach einem der voranstehenden Ansprüche,
**dadurch gekennzeichnet, dass**
der aktive Bereich des Halbleiterlasers (20) eine Doppelheterostruktur oder eine Fünffachstruktur mit getrennter Lokalisation von Ladungsträgern und Photonen, mit Quantentöpfen, Quantendrähten und/oder Quantenpunkten aufweist.

**8.** Optoelektronischer Oszillator (10) nach einem der voranstehenden Ansprüche,
**dadurch gekennzeichnet, dass**
die Länge der Rückkopplungsschleife (80) zwischen 30 m und 34 m liegt.

**9.** Verfahren zum Erzeugen eines optischen und/oder elektrischen Pulskammes mittels eines optoelektronischen Oszillators (10) mit einem monolithisch integrierten modengekoppelten Halbleiterlaser (20) und einer optischen Rückkopplungsschleife (80), die einen Teil der optischen Strahlung des Halbleiterlasers (20) reflektiert und in den Halbleiterlaser (20) als Rückkoppelpulse (Pr) zurückkoppelt, wobei die Dämpfung der Rückkopplungsschleife (80) auf einen Wert zwischen 27,5 und 37,5 dB eingestellt wird, und wobei der Halbleiterlaser (20) ohne Beeinflussung durch die Rückkoppelpulse (Pr) kammartig optische Pulse - nachfolgend Urpulse genannt - emittieren würde und im Falle einer Beeinflussung durch die Rückkoppelpulse ($P_r$) der Rückkopplungsschleife (80) beeinflusste, kammartige Pulse emittiert,
**dadurch gekennzeichnet, dass**

- der Zeitversatz der Rückkopplungsschleife (80) derart eingestellt wird, dass jeder Rückkoppelpuls ($P_r$) innerhalb der zeitlichen Halbwertsbreite eines nachfolgenden Urpulses eintrifft, den der Halbleiterlaser (20) ohne Beeinflussung durch den eintreffenden Rückkoppelpuls ($P_r$) erzeugt hätte, und
- die Länge der Rückkopplungsschleife (80) derart gewählt wird, dass 6000 bis 7000 optische Pulse in ihr umlaufen.

**Claims**

**1.** Optoelectronic oscillator (10) for producing an optical and/or electrical pulse comb,

- comprising a monolithically integrated passive mode-locked semiconductor laser (20) and

comprising an optical feedback loop (80) which guides part of the optical radiation from the semiconductor laser (20) and couples said radiation back into the semiconductor laser (20) as feedback pulses (Pr), wherein the damping of the feedback loop (80) is between 27.5 and 37.5 dB, and
- wherein the semiconductor laser (20) would emit comb-like optical pulses - referred to as primary pulses below - without influence by the feedback pulses (Pr) and emits influenced, comb-like output pulses (Pa) in the case of influence by the feedback pulses (Pr), which output pulses have a smaller temporal jitter or a smaller phase noise than the primary pulses,
**characterized in that**
- the time lag of the feedback loop (80) is selected in such a way that each feedback pulse (Pr) is incident within the temporal full width at half maximum of a subsequent primary pulse which the semiconductor laser (20) would have produced without influence by the incident feedback pulse (Pr), and
- is selected in such a way that 6000 to 7000 optical pulses circulate therein.

2. Optoelectronic oscillator (10) according to Claim 1,
**characterized in that**
the time lag of the feedback loop (80) is selected in such a way that the pulse peak power of each feedback pulse (Pr) is incident within the temporal full width at half maximum of a subsequent primary pulse.

3. Optoelectronic oscillator (10) according to one of the preceding claims,
**characterized in that**
a bias tee (30) is electrically connected to the monolithically integrated mode-locked semiconductor laser (20), by means of which electrical pulses which, in terms of their frequency, correspond to the optical output pulses (Pa) of the semiconductor laser (20) influenced by the feedback pulses (Pr), are decoupled.

4. Optoelectronic oscillator (10) according to Claim 3,
**characterized in that**

- the semiconductor laser (20) comprises a gain section (21), to which a forward voltage (Uv) can be applied, and a saturatable absorber section (22), to which a reverse voltage (Ur) can be applied, and
- the bias tee (30) is electrically connected to the absorber section (22).

5. Optoelectronic oscillator (10) according to Claim 4,
**characterized in that**
the modulated photocurrent from the absorber section (22) is applied to the bias tee (30).

6. Optoelectronic oscillator (10) according to Claim 4 or 5,
**characterized in that**
one connection of the bias tee (30) forms an electrical output for outputting electrical pulses, the pulse profile of which corresponds to, or is identical to, the pulse profile of the output pulses ($P_a$) influenced by the feedback pulses ($P_r$) of the feedback loop (80).

7. Optoelectronic oscillator (10) according to one of the preceding claims,
**characterized in that**
the active region of the semiconductor laser (20) has a double heterostructure or a fivefold structure with separated localization of charge carriers and photons, with quantum wells, quantum wires and/or quantum dots.

8. Optoelectronic oscillator (10) according to one of the preceding claims,
**characterized in that**
the length of the feedback loop (80) lies between 30 m and 34 m.

9. Method for generating an optical and/or electrical pulse comb by means of an optoelectronic oscillator (10) comprising a monolithically integrated mode-locked semiconductor laser (20) and an optical feedback loop (80) which reflects part of the optical radiation from the semiconductor laser (20) and couples said radiation back into the semiconductor laser (20) as feedback pulses (Pr), wherein the damping of the feedback loop (80) is set to a value between 27.5 and 37.5 dB, and wherein the semiconductor laser (20) would emit comb-like optical pulses - referred to as primary pulses below - without influence by the feedback pulses (Pr) and emits influenced, comb-like pulses in the case of influence by the feedback pulses ($P_r$), from the feedback loop (80)
**characterized in that**

- the time lag of the feedback loop (80) is set in such a way that each feedback pulse (P$_r$) is incident within the temporal full width at half maximum of a subsequent primary pulse which the semiconductor laser (20) would have produced without influence by the incident feedback pulse (P$_r$), and
is selected in such a way that 6000 to 7000 optical pulses circulate therein.

**Revendications**

1. Oscillateur optoélectronique (10) destiné à générer un peigne d'impulsions optiques et/ou électriques et comprenant

   - un laser à semi-conducteur (20) à verrouillage de mode passif intégré de manière monolithique et
   - une boucle de rétroaction optique (80) qui guide une partie du rayonnement optique du laser à semi-conducteur (20) et le renvoie dans le laser à semi-conducteur (20) sous forme d'impulsions de rétroaction (Pr), l'amortissement de la boucle de rétroaction (80) étant compris entre 27,5 et 37,5 dB, et
   - le laser à semi-conducteur (20) émettant, sans influence des impulsions de rétroaction (Pr), des impulsions optiques en forme de peigne appelées ci-dessous impulsions d'origine et, en cas d'influence, des impulsions de sortie (Pa) en forme de peigne qui sont influencées par les impulsions de rétroaction (Pr) et qui présentent une instabilité temporelle ou un bruit de phase inférieurs à celle ou celui des impulsions d'origine, **caractérisé en ce que**
   - le décalage temporel de la boucle de rétroaction (80) est sélectionné de manière à ce que chaque impulsion de rétroaction (Pr) entre dans la demi-largeur temporelle d'une impulsion d'origine suivante que le laser à semi-conducteur (20) aurait générée sans l'influence de l'impulsion de rétroaction entrante (Pr) et
   - la longueur de la boucle de rétroaction (80) est sélectionnée de manière à ce que 6000 à 7000 impulsions optiques circulent dans celle-ci.

2. Oscillateur optoélectronique (10) selon la revendication 1, **caractérisé en ce que**
   le décalage temporel de la boucle de rétroaction (80) est sélectionné de manière à ce que la puissance de crête de chaque impulsion de rétroaction (Pr) entre dans la demi-largeur temporelle d'une impulsion d'origine suivante.

3. Oscillateur optoélectronique (10) selon l'une des revendications précédentes,
   **caractérisé en ce que**
   un T de polarisation (30) est raccordé électriquement au laser à semi-conducteur (20) à verrouillage de mode intégré de manière monolithique, le T de polarisation délivrant en sortie des impulsions électriques qui correspondent en fréquence aux impulsions de sortie optiques (Pa) du laser à semi-conducteur (20) qui sont influencées par les impulsions de rétroaction (Pr).

4. Oscillateur optoélectronique (10) selon la revendication 3,
   **caractérisé en ce que**

   - le laser à semi-conducteur (20) comprend une section de gain (21) sur laquelle une tension directe (Uv) peut être appliquée et une section d'absorption saturable (22) sur laquelle une tension inverse (Ur) peut être appliquée et
   - le T de polarisation (30) est raccordé électriquement à la section d'absorption (22).

5. Oscillateur optoélectronique (10) selon la revendication 4,
   **caractérisé en ce que**
   le T de polarisation (30) est soumis au photocourant modulé de la section d'absorption (22).

6. Oscillateur optoélectronique (10) selon la revendication 4 ou 5,
   **caractérisé en ce que**
   une borne du T de polarisation (30) forme une sortie électrique destinée à délivrer des impulsions électriques dont le profil correspond ou est identique au profil des impulsions de sortie (Pa) influencé par les impulsions de rétroaction (Pr) de la boucle de rétroaction (80).

7. Oscillateur optoélectronique (10) selon l'une des revendications précédentes,
   **caractérisé en ce que**
   la région active du laser à semi-conducteur (20) présente une double hétérostructure ou une quintuple structure comportant une localisation séparée des porteurs de charge et des photons, des puits quantiques, des fils quantiques et/ou des points quantiques.

8. Oscillateur optoélectronique (10) selon l'une des revendications précédentes,
**caractérisé en ce que**
la longueur de la boucle de rétroaction (80) est comprise entre 30 m et 34 m.

9. Procédé de génération d'un peigne d'impulsions optique et/ou électrique au moyen d'un oscillateur optoélectronique (10) comportant un laser à semi-conducteur (20) à verrouillage de mode intégré de manière monolithique et une boucle de rétroaction optique (80) qui réfléchit une partie du rayonnement optique du laser à semi-conducteur (20) et qui le renvoie dans le laser à semi-conducteur (20) sous forme d'impulsions de rétroaction (Pr), l'amortissement de la boucle de rétroaction (80) étant réglé à une valeur comprise entre 27,5 et 37,5 dB, et le laser à semi-conducteur (20) émettant, sans influence des impulsions de rétroaction (Pr), des impulsions optiques en forme de peigne appelées ci-dessous impulsions d'origine et, en cas d'influence impulsions de rétroaction (Pr) de la boucle de rétroaction (80) émettant des impulsions en forme de peigne,
**caractérisé en ce que**

- le décalage temporel de la boucle de rétroaction (80) est réglé de manière à ce que chaque impulsion de rétroaction (Pr) entre dans la demi-largeur temporelle d'une impulsion d'origine suivante que le laser à semi-conducteur (20) aurait générée sans l'influence de l'impulsion de rétroaction entrante (Pr) et
- la longueur de la boucle de rétroaction (80) est sélectionnée de manière à ce que 6000 à 7000 impulsions optiques circulent dans celle-ci.

**Fig. 1**

EP 3 011 648 B1

Fig. 2 (a)

Fig. 2 (b)

EP 3 011 648 B1

Fig. 2 (c)

Fig. 3

EP 3 011 648 B1

Fig. 4 (b)

Fig. 4 (a)

Fig. 5 (b)

Fig. 5 (a)

**Fig. 5 (c)**

Fig. 6

Fig. 7

Fig. 8

EP 3 011 648 B1

Fig. 9

HWB

Urpuls: HWB= 5.3 ps

Rückgekoppelter
Puls

-2.6    0    2.6    Puls-zu-Puls-Abstand [ps]

Fig. 10

EP 3 011 648 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **CHANG-YI LIN et al.** Microwave Characterization and Stabilization of Timing Jitter in a Quantum-Dot Passively Mode-Locked Laser via External Optical Feedback. *IEEE JOURNAL OF SELECTED TOPICS IN QUANTUM ELECTRONICS,* 01. September 2011, vol. 17 (5), 1311-1317
- **L. MALEKI.** The optoelectronic oscillator. *Nature Photonics - Industry Perspective,* Dezember 2011, 728-730
- **S. K. TEWKSBURY ; L. A. HORNAK.** Optical Clock Distribution in Electronic Systems. *Journal of VLSI Signal Processing,* 1997, 225-246
- **P. J. DELFYETT ; D. H. HARTMANN ; S. Z. AHMAD.** Optical Clock Distribution Using a Mode-Locked Semiconducrtor Laser Diode System. *Journal of Lightwave Technology,* Dezember 1991, 1646-1649
- **H. A. HAUS.** Mode-locking of lasers. *IEEE Journal of Selected Topics in Quantum Electronics,* November 2000, vol. 6 (6), 1173-1185
- **D. BIMBERG.** Quantum dot based nanophotonics and nanoelectronics. *Electronics Letters,* Januar 2008, vol. 44 (3), 168-171
- **M. KUNTZ ; G. FIOL ; M. LÄMMLIN ; C. MEUER ; D. BIMBERG.** High-Speed Mode-Locked Quantum-Dot Lasers and Optical Amplifiers. *Proceedings of the IEEE,* September 2007, vol. 95 (9), 1767-1778
- **J. LASRI ; A. BILENCA ; D. DAHAN ; V. SIDOROV ; G. EISENSTEIN ; D. RITTER ; K. YVIND.** A Self-Starting Hybrid Optoelectronic Oscillator Generating Ultra Low Jitter 10-GHz Optical Pulses and Low Phase Noise Electrical Signals. *IEEE Photonics Technology Letters,* Juli 2002, 1004-1006
- **C. W. NELSON ; A. HATI ; D. A. HOWE ; W. ZHOU.** Microwave Optoelectronic Oscillator with Optical Gain. *National Institute of Standards and Technology (NIST),* 2007
- **N. YU ; E. SALIK ; L. MALEKI.** Ultralow-noise mode-locked laser with coupled optoelectronic oscillator configuration. *Optics Letters,* Mai 2005, 1231-1233
- **G. FIOL ; M. KLEINERT ; D. ARSENIJEVIC ; D. BIMBERG.** 1.3 µm range 40 GHz quantum-dot mode-locked laser under external continuous wave light injection or optical feedback. *Semiconductor Science and Technology,* November 2010, vol. 26 (1), 014006
- **F. KEFELIAN ; S. O'DONOGHUE ; M. T. TODARO ; J. G. MCINERNEY ; G. HUYET.** RF Linewidth in Monolithic Passively Mode-Locked Semiconductor Laser. *IEEE Photonics Technology Letters,* 15. August 2008, vol. 20 (16), 1405-1407
- **D. VON DER LINDE.** Characterization of the Noise in Continuously Operating Mode-Locked Lasers. *Applied Physics B,* 1986, vol. 39, 201-207
- **G. FIOL.** 1.3 µm Monolithic Mode-Locked Quantum-Dot Semiconductor Lasers. Mensch und Buch Verlag, 2011
- Micro-Opto-Electronic Oscillator (uOEO). OEWaves Inc, 2012